(19) Europäisches Patentamt
European Patent Office
Office européen des brevets

(11) **EP 1 354 425 B1**

(12) **EUROPÄISCHE PATENTSCHRIFT**

(45) Veröffentlichungstag und Bekanntmachung des Hinweises auf die Patenterteilung:
**03.08.2005 Patentblatt 2005/31**

(51) Int Cl.⁷: **H04B 3/00**

(21) Anmeldenummer: 02714096.1

(86) Internationale Anmeldenummer:
**PCT/EP2002/000553**

(22) Anmeldetag: **21.01.2002**

(87) Internationale Veröffentlichungsnummer:
**WO 2002/060085 (01.08.2002 Gazette 2002/31)**

(54) **FILTERANORDNUNG**

FILTER ARRANGEMENT

ENSEMBLE FILTRE

(84) Benannte Vertragsstaaten:
**AT BE CH CY DE DK ES FI FR GB GR IE IT LI LU MC NL PT SE TR**

(30) Priorität: **22.01.2001 DE 10102720**

(43) Veröffentlichungstag der Anmeldung:
**22.10.2003 Patentblatt 2003/43**

(73) Patentinhaber: **Vacuumschmelze GmbH & Co. KG 63450 Hanau (DE)**

(72) Erfinder: **HEUMANN, Dirk 61130 Nidderau (DE)**

(74) Vertreter: **Schmuckermaier, Bernhard PAe Westphal, Mussgnug & Partner, Mozartstrasse 8 80336 München (DE)**

(56) Entgegenhaltungen:
**WO-A-00/48314          DE-A- 4 306 512**

## Beschreibung

Die Erfindung betrifft eine Filteranordnung insbesondere für Telefonieanwendungen.

Die ADSL-Technologie ist eine Breitband-Telekommunikationstechnologie zum Verbinden von Endteilnehmern mit einer Vermittlungsstelle. ADSL steht dabei für Asymetric Digital Subscriber Line. Die Übertragungsraten sind asymetrisch miteiner hohen Übertragungsrate (> 1,5MBit/s) von der Vermittlungsstelle zum Endteilnehmer und einer niedrigeren Übertragungsrate (< 800kBit/s) vom Endteilnehmer zur Vermittlungsstelle. Neben der ADSL-Übertragung sollen daneben auch Telefongespräche über die selbe Leitung geführt werden können. Zur Telefonie sollen dabei sowohl digitale Übertragungstechnik (ISDN = Integrated Servcies Digital Network) und analoge Übertragungstechnik (POTS = Plain Old Telephone System) genutzt werden. Damit Telefonie und ADSL-Übertragung sich nicht gegenseitig beeinflussen, wird ein sogenannter Splitter, das heißt eine Filterweiche mit Hochpassfilter und Tiefpassfilter, an das Ende der Übertragungsleitung geschaltet, wobei über den Hochpass die ADSL-Übertragung erfolgt und über den Tiefpass die Telefonie abgewickelt wird.

An das Tiefpassfilter werden besondere Anforderungen bezüglich Übertragungsfunktion, Gruppenlaufzeitverzerrung und Reflexionsdämpfung gestellt. So liegen beispielsweise die Anforderungen bezüglich der Reflexionsdämpfung für analoge Telefone im Bereich von 200 Hz bis 4 kHz bei einer Reflexionsdämpfung >18dB sowie für 16 kHz bei einer Reflexionsdämpfung >14dB. Ein Problem bei der Realisierung derartiger Tiefpassfilter liegt darin, dass Standardfilter auf reelle AbschlussImpedanzen (ohmsche Widerstände) ausgelegt sind (vgl. A. I. Zverev, Handbook of Filter Synthesis, Wiley & Sons, New York 1967), während den für POTS-Anwendungen vorgesehenen Tiefpassfiltern eine komplexe Abschluss-Impedanz (in Deutschland beispielsweise 220 Ohm in Reihe zu einer Parallelschaltung aus einem 820-Ohm-Widerstand und einem 150 nF-Kondensator) zugrundegelegt wird. Es hat sich dabei herausgestellt, dass mit Standardfiltern die Reflexionsdämpfungsanforderungen nicht zu erfüllen sind.

Aus der DE 198 57 428 A1 ist eine Filteranordnung zum Anschluss reeller Abschlussimpedanzen an eine Signalquelle bekannt, die ein Standardfilter für diese bestimmte reelle Abschluss-Impedanz anpasst. Dem Standardfilter ist eingangsseitig eine erste Anpass-Impedanz und ausgangsseitig eine zweite Aripass-Impedanz parallel geschaltet, wobei die zweite Anpass-Impedanz gleich der negativen ersten Anpass-Impedanz bei einer bestimmten Frequenz ist. Diese Filteranordnung ist jedoch für ADSL-Anwendungen ungeeignet.

Aufgabe der Erfindung ist es, eine Filteranordnung anzugeben, die sowohl für die Einfüge- als auch für die Reflexionsdämpfung bessere Werte als die bekannten Filter erbringen.

Die Aufgabe wird gelöst durch eine Filteranordnung gemäß Patentanspruch 1. Ausgestaltungen und Weiterbildungen des Erfindungsgedankens sind Gegenstand von Unteransprüchen.

Vorteil der Erfindung ist es, dass bei der erfindungsgemäßen Filteranordnung von einem Standardfilter, das für einen reellen Abschlusswiderstand ausgelegt ist, ausgegangen werden kann. Dieses Filter wird dann auf einfache Weise und mit verhältnismäßig geringem Aufwand für die jeweilige Anwendung an komplexe Abschlusswiderstände angepasst. Somit ist der Aufwand sowohl für die Berechnung des Filters als auch für dessen Herstellung sehr gering, da auf Standardelemente (Standardfilter) zurückgegriffen werden kann.

Erreicht wird dies im einzelnen durch eine Filteranordnung zum Anschluss komplexer Anschlussimpedanzen an eine Signalquelle mit einem für eine bestimmte reelle Abschluss-Impedanz ausgelegten Standardfilter, einer dem Standardfilter eingangsseitig parallel geschalteten ersten Anpass-Impedanz und einer dem Standardfilter ausgangsseitig parallel geschalteten zweiten Anpass-Impedanz, wobei die zweite Anpass-Impedanz gleich der negativen ersten Ausgangsimpedanz über den gesamten Durchlassbereich der Filteranordnung ist.

Bei einer Weiterbildung der Erfindung ist die zweite Impedanz gleich dem Produkt aus komplexer und reeller Abschluss-Impedanz geteilt durch die Differenz aus komplexer und reeller Abschluss-Impedanz. Auf diese Weise lässt sich ohne größeren Aufwand die optimale Abschluss-Impedanz ermitteln und einstellen.

Bevorzugt wird dabei die Bildung einer negativen Impedanz mittels eines Negativ-Impedanz-Converters (NIC)aus einer zu der anderen Anpass-Imdedanz identischen Impedanz erzeugt.

Die Filteranordnung wird insbesondere in Verbindung mit Signalquellen verwendet, bei denen der Innenwiderstand gleich der komplexen Abschluss-Impedanz ist (Leistungsanpassung).

Als Standardfilter wird bevorzugt ein Tiefpassfilter vorgesehen, das vorzugsweise genormt ist und/oder vorzugsweise Bestandteil eines Splitters zum Anschluss von analogen Telefonen (oder alternativ ISDN-Telefonen) und ADSL-Systemen an ein und dieselbe Telefonleitung ist.

Die Erfindung wird nachfolgend anhand der in den Figuren der Zeichnung dargestellten Ausführungsbeispiele näher erläutert. Es zeigt:

Figur 1 ein erstes Ausführungsbeispiel einer erfindungsgemäßen Filteranordnung mit unsymmetrischem Aufbau und

Figur 2 ein zweites Ausführungsbeispiel einer erfindungsgemäßen Filteranordnung mit symmetrischem Aufbau.

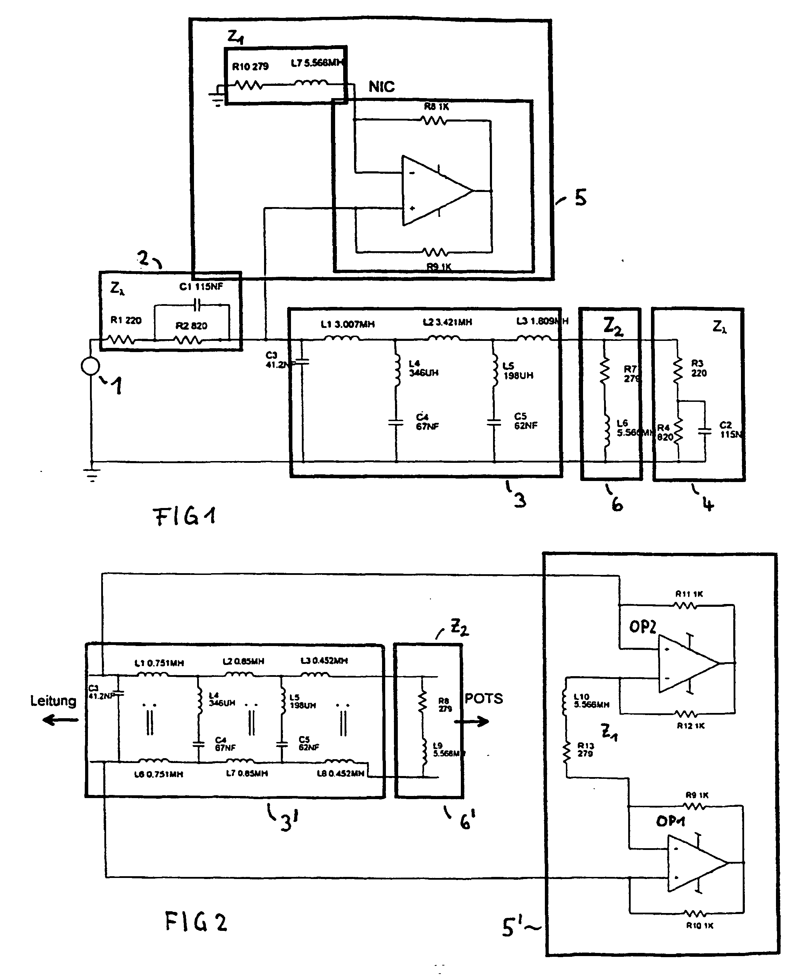

Gemäß Fig. 1 ist an eine Signalquelle 1 mit einer Innenimpedanz 2 ein Standardfilter 3 angeschlossen, das wiederum durch eine Abschluss-Impedanz 4 abgeschlossen wird. Erfindungsgemäß werden zwei Anpass-Impedanzen 5 und 6 im Querzweig vor und hinter dem Standardfilter 3 hinzugefügt, wodurch optimale Reflexions- und Einfügedämpfungswerte erzielt werden. Wird nun angenommen, dass die Innenimpedanz 2 und die Abschlussimpedanz 4 jeweils einen Wert $Z_\lambda$ aufweisen und dass die Anpass-Impedanzen 5 und 6 Werte $Z_1$ bzw. $Z_2$ haben, dann ergeben sich für den Fall, dass das Standardfilter 3 für einen Abschlusswiderstand R ausgelegt ist, die nachfolgend beschriebenen Zusammenhänge.

Ist der Wert $Z_\lambda$, der für den komplexen charakteristischen Wellenwiderstand steht, gegeben, so können unter der Bedingung der Anpassung über den gesamten Durchlassbereich des Standardfilters bzw. der Filteranordnung nun die Werte $Z_1$ und $Z_2$ bestimmt werden.

$$Z_2 \parallel Z_\lambda = R = (Z_2 \cdot Z_\lambda / Z_2 + Z_\lambda) \qquad (1)$$

Der Widerstand R wird dann durch das auf den Widerstand R ausgelegte Standardfilter 3 an den Reflexionsnullstellen des Standardfilters 3 als Widerstand R parallel zum Wert $Z_1$ der Anpass-Impedanz 5 transformiert. Als zweite Bedingung ergibt sich somit

$$Z_1 \parallel R = Z_\lambda = (Z_1 \cdot R / Z_1 + R) \qquad (2)$$

Aus den Gleichungen (1) und (2) folgt:

$$Z_2 = -Z_1 = Z \qquad (3)$$

Das bedeutet, dass der Wert $Z_1$ der Anpass-Impedanz 1 aus dem Wert $Z_2$ der Anpass-Impedanz 6 durch eine Transformation (negative Impedanz-Conversion) erzeugt werden kann.

Der Wellenwiderstand mit dem Wert $Z_\lambda$ ergibt sich zu:

$$Z_\lambda = R_1 + Z_p \text{ mit} \qquad (4)$$

$$Z_p = R_2 \parallel (1/pC) \qquad (5)$$

Die erfindungsgemäße Filteranordnung wird nun auf den ersten ohmschen Widerstand $R_1$ des charakteristischen Wellenwiderstandes ($Z_\lambda$) ausgelegt. Es wird hierdurch eine einfache Form für die Anpassimpedanzen 5 und 6 erzielt.

Der Anpasswiderstand für das Standardfilter 3 wird zu R gewählt. Daraus ergibt sich:

$$Z = (Z_\lambda \cdot R)/(Z_\lambda - R) \qquad (6)$$

Hieraus ergibt sich mit $Z_\lambda = R + Z_p$:

$$Z = R \ (R + Z_p)/Z_p \qquad (7)$$

Mit $Z_p = R_2/(1 + p \ C \ R_2)$ ergibt sich:

$$Z = ((R^2/R_2) + R) + pCR^2 = R_0 + pL_0 \qquad (8)$$

Die negative Impedanz wird dabei bevorzugt aus der positiven Impedanz (bzw. einer zu dieser identischen Impedanz) mittels negativer Impedanzkonversion erzeugt.

Es ist zu beachten, dass die Impedanz Z nur dann durch passive Bauelemente realisiert werden kann, wenn im obigen Fall $R = R_1$ gewählt wurde. Wird der reelle Wellenwiderstand der Filteranordnung anders gewählt, so ist in der Regel keine Realisierung möglich.

Eine symmetrisch aufgebaute Ausführungsform einer erfindungsgemäßen Filteranordnung ist in Figur 2 gezeigt. Ausgehend von der in Figur 1 dargestellten allgemeinen Ausführungsform wird ein Standardfilter 3 verwendet, das nach deutscher Norm ausgelegt und an einen Widerstand R = 220 Ohm angepasst ist. Dieses Filter weist im eingangsseitigen Querzweig einen Kondensator C3 (41,2 nF) auf. Darüber hinaus sind zwei weitere Querzweige vorgesehen, die jeweils aus einer Induktivität L4, L5 (346 µH, 198 µH) sowie einer Kapazität C4, C5 (67 nF, 62 nF) bestehen. Die einzelnen Querzweige sind der Reihe nach über jeweils eine Induktivität L1, L2 (3,007 mH, 3,421 mH) miteinander verbunden. Darüber hinaus ist der ausgangsseitige Querzweig über eine weitere Induktivität L3 (1,809 mH) mit dem Ausgang des Standardfilters 3 verbunden. Aufgrund der unsymmetrischen Ausbildung des Standardfilters 3 sind die Induktivitäten L1 bis L3 dabei jeweils nur auf einer Seite der Querzweige angeordnet.

Eingangsseitig ist das Standardfilter 3 über die InnenImpedanz 2 an die Signalquelle 1 angeschlossen. Der Wert $Z_\lambda$ der Innen-Impedanz 2 setzt sich dabei aus dem Widerstand $R_1$ (220 Ohm) sowie einer dazu in Reihe geschalteten Parallelschaltung aus dem Widerstand $R_2$ (820 Ohm) und einer Kapazität C1 (115 nF) zusammen. Ein Widerstand R3 entspricht dabei dem Widerstand R1, ein Widerstand R4 dem Widerstand R2 und eine Kapazität C2 der Kapazität C1.

Die Anpass-Impedanzen 5 und 6 haben einen einander gegenüber negativen, ansonsten aber gleichen Wert Z. Die Abschluss-Impedanz 6 ist beim Ausführungsbeispiel dabei rein passiv ausgeführt und umfasst einen Widerstand R7 (279 Ohm) sowie eine dazu in Reihe geschaltete Induktivität L6 (5,568 mH), die einen Querzweig bildend der Abschluss-Impedanz 4 parallel geschaltet sind. Die Anpass-Impedanz 5 geht dabei wiederum von dem gleichen Wert Z aus, der beim Ausführungsbeispiel mittels des Widerstandes R10 (279 Ohm) und der Induktivität L7 (5,566 mH) in Reihe gebildet wird. Somit entspricht der Widerstand R10 dem Widerstand R7 und die Induktivität L7 der Induktivität L6. Aus dieser positiven Impedanz wird mittels eines Negativ-Impedanz-Converters (NIC) dann die entsprechende negative Impedanz erzeugt. Der Negativ-Impedanz-Converter besteht aus einem Operationsverstärker OP, dessen invertierender Eingang zum einen über Widerstand R10 und Induktivität L7 mit einem Bezugspotential und zum anderen über einen Widerstand R8 (1 kOhm) mit seinem eigenen Ausgang verbunden ist. Der nicht invertierende Eingang des Operationsverstärkers OP ist wiederum zum einen über einen Widerstand R9 (1 kOhm) mit seinem eigenen Eingang und zum anderen mit dem dem Bezugspotential abgewandten Eingang des Standardfilters 3 verbunden.

Das Ausführungsbeispiel nach Figur 3 geht aus dem in Figur 2 gezeigten Ausführungsbeispiel dadurch hervor, dass das Standardfilter 3 sowie die Anpass-Impedanzen 5 und 6 symmetrisch ausgeführt sind. Der besseren Übersichtlichkeit halber sind in Fig. 3 deshalb auch nur diese Elemente dargestellt. Das symmetrische Standardfilter 3' geht aus dem unsymmetrischen Standardfilter 3 aus Fig. 2 dadurch hervor, dass die in den Längszweigen angeordneten Induktivitäten L1, L2 und L3 jeweils in zwei einzelne gleiche Induktivitäten aufgespalten sind, die zusammen die gleiche Induktivität aufweisen wie die jeweils einzelnen Induktivitäten der unsymmetrischen Ausführungsform. Ansonsten stimmen beide Standardfilter 3, 3' in ihren Werten und ihren Aufbau überein. Die Anpass-Impedanz 6' aus Fig. 3 mit einem Widerstand R8 und einer Induktivität R9 stimmt im wesentlichen mit der Anpass-Induktivität 6 aus Fig. 2 überein, da aufgrund des einzigen Querzweiges symmetrische und unsymmetrische Ausführungsformen identisch sind.

Eine Anpass-Impedanz 5', welche die symmetrische Ausführung der Anpass-Impedanz 5 aus Fig. 2 darstellt, weist eine Reihenschaltung einer Induktivität L10 und eines Widerstandes R13 in Reihe zueinander auf, die eine Impedanz bilden, welche identisch zur Anpass-Impedanz 6' ist. Jeweils ein Anschluss dieser nachgebildeten Anpass-Impedanz (L10, R13) ist mit dem invertierenden Eingang jeweils eines Operationsverstärkers OP1, OP2 verbunden, wobei die invertierenden Eingänge über jeweils einen Widerstand R9 bzw. R12 mit dem Ausgang des jeweiligen Operationsverstärkers OP1, OP2 verbunden sind. Darüber hinaus sind auch die jeweiligen nicht invertierenden Eingänge der Operationsverstärker OP1 und OP2 mit dem jeweiligen Ausgang verbunden, wobei die nicht invertierenden Eingänge zu dem mit jeweils einem Eingangsanschluss des Standardfilters 3' gekoppelt sind.

Wie gezeigt wurde, weisen erfindungsgemäße Filteranordnungen gegenüber den dabei verwendeten, für sich alleine jedoch ungeeigneten Standardfiltern einen nur äußerst geringen zusätzliche Aufwand auf, um die geforderten Eigenschaften zu realisieren.

Bezugszeichenliste:

| 1 | Signalquelle |
| 2 | Innen-Impedanz |
| 3 | Standardfilter |
| 4 | Abschluss-Impedanz |
| 5 | Anpass-Impedanz |
| 6 | Anpass-Impedanz |
| $C_1$-$C_5$ | Kapazität |
| $L_1$-$L_5$ | Induktivität |
| $R_1$-$R_7$ | Widerstand |
| NIC | Negativ-Impedanz-Converter |
| OP | Operationsverstärker |

**Patentansprüche**

1. Filteranordnung zum Anschluss komplexer Abschlussimpedanzen an eine Signalquelle (1) mit
    einem für eine bestimmte reelle Abschluss-Impedanz (4) ausgelegten Standardfilter,
    einer dem Standardfilter (3) eingangsseitig parallel geschalteten ersten Anpass-Impedanz (5) und
    einer dem Standardfilter (3) ausgangsseitig parallel geschalteten zweiten Anpass-Impedanz (6), wobei
    die zweite Anpass-Impedanz (6) gleich der negativen ersten Anpass-Impedanz (5) über den gesamten Durchlassbereich der Filteranordnung ist.

2. Filteranordnung nach Anspruch 1, bei der die zweite Anpass-Impedanz (6) gleich dem Produkt aus komplexer und reeller Abschluss-Impedanz (4) geteilt durch die Differenz aus komplexer und reeller Abschluss-Impedanz (4) ist.

3. Filteranordnung nach Anspruch 1 oder 2, bei der eine der Anpass-Impedanzen (5, 6) aus einer zu der anderen Anpass-Impedanz (5, 6) identischen Impedanz mittels eines Negative-Impedanz-Converters (NIC) erzeugt wird.

4. Filteranordnung nach einem der Ansprüche 1 bis 3, bei der der Innenwiderstand der Signalquelle (1) gleich der komplexen Abschluss-Impedanz (4) ist.

5. Filteranordnung nach einem der Ansprüche 1 bis 4, bei der das Standardfilter (3) ein Tiefpassfilter ist.

6. Filteranordnung nach Anspruch 5, bei der das Tiefpassfilter Bestandteil eines Splitters zum Anschluss von analogen Telefonen und ADSL-Systemen an Telefonleitungen ist.

## Claims

1. Filter arrangement for connecting complex terminating impedances to a signal source (1), comprising a standard filter designed for a specific real terminating impedance (4), a first matching impedance (5) connected in parallel with the standard filter (3) on the input side and a second matching impedance (6) connected in parallel with the standard filter (3) on the output side, the second matching impedance (6) being equal to the negative first matching impedance (5) over the entire passband of the filter arrangement.

2. Filter arrangement according to claim 1, in which the second matching impedance (6) is equal to the product of the complex and real terminating impedances (4) divided by the difference between the complex and real terminating impedances (4).

3. Filter arrangement according to claim 1 or claim 2. in which one of the matching impedances (5. 6) is produced from an impedance identical to the other matching impedance (5, 6) by means of a negative impedance converter (NIC).

4. Filter arrangement according to one of claims I to 3. in which the internal resistance of the signal source (1) is equal to the complex terminating impedance (4).

5. Filter arrangement according to one of claims 1 to 4, in which the standard filter (3) is a low-pass filter.

6. Filter arrangement according to claim 5, in which the low-pass filter is part of a splitter for connecting analog telephones and ADSL systems to telephone lines.

## Revendications

1. Filtre pour brancher des impédances terminales sur une source de signaux (1) comprenant :

   - un filtre standard conçu pour une certaine impédance terminale réelle (4),
   - une première impédance d'adaptation (5) branchée en parallèle du côté de l'entrée du filtre standard (3) et
   - une seconde impédance d'adaptation (6) branchée en parallèle en sortie sur le filtre standard (3),

   la seconde impédance d'adaptation (6) étant égale à la première impédance d'adaptation (5), négative, pour toute la plage passante du filtre.

2. Filtre selon la revendication 1,
   **caractérisé en ce que**
   la seconde impédance adaptatrice (6) est égale au produit d'une impédance terminale complexe et réelle (4) divisé par la différence de l'impédance terminale complexe et réelle (4).

3. Filtre selon l'une des revendications 1 ou 2, dont l'une des impédances adaptatrice (5, 6) est obtenue à partir d'une impédance identique à l'autre impédance adaptatrice (5, 6) obtenue par un convertisseur d'impédance négative (NIC).

4. Filtre selon l'une des revendications 1 à 3, dans lequel la résistance interne de la source de signaux (1) est égale à l'impédance terminale complexe (4).

5. Filtre selon l'une des revendications 1 à 4, dans lequel le filtre standard (3) est un filtre passe-bas.

6. Filtre selon la revendication 5, dans lequel le filtre passe-bas fait partie d'un répartiteur pour brancher des téléphones analogiques et des systèmes ADSL sur des lignes téléphoniques.

FIG 1

FIG 2